(19) Europäisches Patentamt
European Patent Office
Office européen des brevets

(11) **EP 1 189 089 B1**

(12) **EUROPÄISCHE PATENTSCHRIFT**

(45) Veröffentlichungstag und Bekanntmachung des Hinweises auf die Patenterteilung:
**25.04.2007  Patentblatt 2007/17**

(21) Anmeldenummer: 01119485.9

(22) Anmeldetag: **14.08.2001**

(51) Int Cl.:
*G02B 17/00* (2006.01)    *G02B 17/02* (2006.01)
*G02B 19/00* (2006.01)    *G02B 26/08* (2006.01)
*G02B 7/00* (2006.01)    *G02B 7/185* (2006.01)
*G03F 7/20* (2006.01)

(54) **Vorrichtung zum Bündeln der Strahlung einer Lichtquelle**

Device for concentrating radiation of a light source

Dispositif de concentration du rayonnement d' une source de lumière

(84) Benannte Vertragsstaaten:
**DE FR GB NL**

(30) Priorität: **13.09.2000  DE 10045265**

(43) Veröffentlichungstag der Anmeldung:
**20.03.2002  Patentblatt 2002/12**

(73) Patentinhaber: **Carl Zeiss SMT AG**
**73447 Oberkochen (DE)**

(72) Erfinder:
• **Antoni, Martin**
**73434 Aalen (DE)**
• **Melzer, Frank**
**73469 Utzmemmingen (DE)**
• **Seifert, Andreas**
**73434 Aalen (DE)**
• **Singer, Wolfgang**
**73431 Aalen (DE)**

(74) Vertreter: **Lorenz, Werner**
**Lorenz & Kollegen**
**Patent- und Rechtsanwaltskanzlei**
**Alte Ulmer Strasse 2-4**
**89522 Heidenheim (DE)**

(56) Entgegenhaltungen:
**EP-A- 0 744 641**        **US-A- 4 664 488**
**US-A- 5 142 132**

• **PATENT ABSTRACTS OF JAPAN vol. 013, no. 294 (P-894), 7. Juli 1989 (1989-07-07) -& JP 01 074502 A (AGENCY OF IND SCIENCE & TECHNOL), 20. März 1989 (1989-03-20)**
• **PATENT ABSTRACTS OF JAPAN vol. 001, no. 095 (E-040), 29. August 1977 (1977-08-29) -& JP 52 029748 A (AGENCY OF IND SCIENCE & TECHNOL), 5. März 1977 (1977-03-05)**
• **PATENT ABSTRACTS OF JAPAN vol. 1997, no. 11, 28. November 1997 (1997-11-28) -& JP 09 178922 A (MITSUBISHI ELECTRIC CORP), 11. Juli 1997 (1997-07-11)**
• **PATENT ABSTRACTS OF JAPAN vol. 1996, no. 08, 30. August 1996 (1996-08-30) -& JP 08 101299 A (AGENCY OF IND SCIENCE &AMP;TECHNOL; SHIMADZU CORP), 16. April 1996 (1996-04-16)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 1 189 089 B1

**Beschreibung**

Die Erfindung betrifft eine Vorrichtung zum Bündeln der Strahlung einer Lichtquelle, insbesondere einer Laser-Plasmaquelle, mit einem Kollektorspiegel nach der im Oberbegriff von Anspruch 1 näher definierten Art.

In der Halbleiter-Lithographie wird häufig eine Lichtquelle verwendet, z.B. eine Laser-Plasmaquelle, deren Licht über einen Kollektorspiegel in einem zweiten Fokus, virtuell oder reell, gesammelt und dann zur Strahlformung in ein Beleuchtungssystem geleitet wird. Durch die Laser-Plasmaquelle erwärmt sich der Kollektorspiegel, wodurch es zu entsprechenden Formänderungen kommt, welche negative Auswirkungen auf das nachfolgende Beleuchtungssystem haben, wie z.B. Beleuchtungsfehler, z.B. Telezentriefehler, Uniformity-Fehler, was zu Lichtverlusten führt.

Zur Vermeidung dieser Nachteile ist es bekannt, den Kollektorspiegel zu kühlen, um die entstehende Wärme abzuführen. Unabhängig von dem hierfür erforderlichen großen Aufwand bestehen trotzdem aufgrund unvermeidlicher Toleranzen weiterhin Probleme bezüglich der Abbildungsgenauigkeit, welche unter anderem auf ein Lageänderung des zweiten Fokuses zurückzuführen sind. Hinzu kommt, dass bei hohen thermischen Lasten, welche bei Pulsbetrieb stark zeitlich variieren können, der Kollektorspiegel nicht vollständig auf einem konstanten Temperaturniveau gehalten werden kann und somit ein "dynamisches" Kühlsystem erforderlich machen würde.

Zum Stand der Technik wird auf die EP 0 744 641 A2, in der die Verwendung verformbar gelagerter Spiegel zur Formanpassung offenbart ist, und auf die JP 63 027 015, JP 04 256 944 und JP 02 017 626 verwiesen.

Der vorliegenden Erfindung liegt die Aufgabe zugrunde, eine Vorrichtung zu schaffen, bei der die Nachteile des Standes der Technik vermieden werden, insbesondere bei der die optischen Eigenschaften eines Kollektorspiegels auch unter thermischer Last in unveränderter Form erhalten bleiben, so dass keine negativen Auswirkungen auf das nachfolgende Beleuchtungssystem auftreten.

Erfindungsgemäß wird diese Aufgabe durch die im kennzeichnenden Teil von Anspruch 1 genannten Merkmale gelöst. Dadurch, dass man gezielt den Kollektorspiegel in z-Richtung, d.h. in Richtung der optischen Achse, verschiebt und der Kollektorspiegel selbst derart ausgelegt ist, dass bei Temperaturänderung die Lage des zweiten Fokus unverändert bleibt, werden die optischen Eigenschaften des Kollektorspiegels auch unter thermischer Last in unveränderter Form beibehalten.

Erfindungsgemäß wird in einer ersten konstruktiven Lösung vorgeschlagen, den Kollektorspiegel so zu lagern oder auszugestalten, dass sich seine Form entsprechend einer isofokalen Kurvenschar, z.B. einer Ellipsenschar, einer Hyperbelschar oder einer Parabelschar verformt. Mit "isofokalen" Kurvenschar ist gemeint, dass sich der Abstand von der Quelle, d.h. vom ersten Fokus bis zum zweiten Fokus nichts ändert. Im weiteren wird zur Vereinfachung nur von Ellipsenschar gesprochen. Eine isofokale Ellipsenschar bildet eine Quelle in ein ortsfestes Bild der Quelle ab. Verformt sich nun der Kollektorspiegel unter Erwärmung entsprechend der isofokalen Ellipsenschar, so bleiben dessen optische Eigenschaften konstant. Dies bedeutet, es ist dann nicht mehr erforderlich, den Kollektorspiegel mit großem Aufwand zu kühlen bzw. auf einer konstanten Temperatur zu halten, sondern man läßt Erwärmungen zu, sorgt jedoch dafür, dass sich die daraus resultierende Formänderung des Kollektorspiegels so verhält, dass ausgesuchte optischen Eigenschaften unverändert bleiben.

Für einen derartigen isofokalen Kollektorspiegel können die konische Konstante K und der Halbparameter p = R in guter Näherung durch lineare Funktionen von der Schnittweite zwischen der Quelle und dem Scheitelpunkt des Kollektorspiegels dargestellt werden.

Wenn andererseits vermieden werden soll, dass eine an sich normalerweise vernachlässigbare Vergrößerungsänderung durch eine Änderung bzw. Verschiebung des Kollektorspiegels auftritt, dann muß als zweite Lösung der Abstand von der Quelle zur Abbildungsebene der Lichtquelle verändert werden. Dies kann z.B. aktiv oder auch über eine passive thermische Ausdehnung erfolgen. Für einen derartigen vergrößerungserhaltenden Kollektorspiegel muß die Exzentrizität $\gamma$ bzw. konische Konstante K konstant bleiben und die Scheitelkrümmung p = R sich linear ändern. Diese Lösung ist unter Umständen bei einem System mit kritischer Beleuchtung von Vorteil, weil dann das Bild der Lichtquelle auf dem Reticle gleich groß bleibt.

Im Unterschied zu der Lösung mit der isofokalen Kurvenschar, wobei der Abstand zwischen dem ersten und dem zweiten Fokus gleich bleibt, bleibt bei dieser alternativen Lösung der Öffnungswinkel der Strahlung vom Kollektorspiegel zum zweiten Fokus gleich, der sich dadurch entsprechend verschiebt. Wenn der zweite Fokus an der gleichen Stelle bleiben soll, muß demzufolge entsprechend nicht nur der Kollektorspiegel in z-Richtung bewegt werden, sondern auch die Quelle bzw. der erste Fokus.

Da im allgemeinen Kollektorspiegel eine anisotrope thermische Last erleiden, kann man in einer erfindungsgemäßen Ausgestaltung vorsehen, dass der Kollektorspiegel mit inhomogen verteilten Kühleinrichtungen derart versehen wird, dass im Kollektorspiegel eine wenigstens annähernd gleichmäßige Temperaturverteilung erreicht wird. Dies bedingt zwar einen höheren Aufwand, aber im Vergleich zu bekannten Kühleinrichtungen kann dieser Aufwand deutlich niedriger gehalten werden, denn es ist nicht erforderlich, eine gesamte Kühlung des Kollektorspiegels durchzuführen, sondern lediglich für eine weitgehend gleichmäßige Temperaturverteilung zu sorgen.

Konstruktive Ausgestaltungen zur gezielten Durchführung der Formänderung des Kollektorspiegels in der gewünschten Weise sind prinzipmäßig in den Unteransprüchen und in den nachfolgend anhand der Zeichnung schematisch beschriebenen Ausführungsbeispielen schematisch erläutert.

Es zeigt:

**Figur 1** Schematische Darstellung eines in einem EUV-Beleuchtungssystem für die Mikrolithographie angeordneten erfindungsgemäßen Kollektorspiegels;

**Figur 2** Prinzipdarstellung des Strahlungsverlaufes zwischen dem Kollektorspiegel und dem zweiten Fokus für eine isofokale Ellipsenschar;

**Figur 3** Prinzipdarstellung des Strahlungsverlaufes zwischen dem Kollektorspiegel und dem zweiten Fokus für eine Beibehaltung der Vergrößerung;

**Figur 4** eine erste Lagerungsart für den erfindungsgemäßen isofokalen Kollektorspiegel;

**Figur 5** eine Lagerung eines isofokalen Kollektorspiegels mit einer Biegefeder;

**Figur 6** eine Lagerung eines isofokalen Kollektorspiegels mit aktiven Komponenten;

**Figur 7** eine Lagerung eines isofokalen Kollektorspiegels mit einer zusätzlichen Abstandsveränderung bei Temperaturerhöhung;

**Figur 8** eine Lagerung für einen isofokalen Kollektorspiegel mit einer reduzierten Lageänderung bei Temperaturerhöhung; und

**Figur 9** eine Lagerung eines isofokalen Kollektorspiegels in einer Fassung über eine Parallelogrammführung.

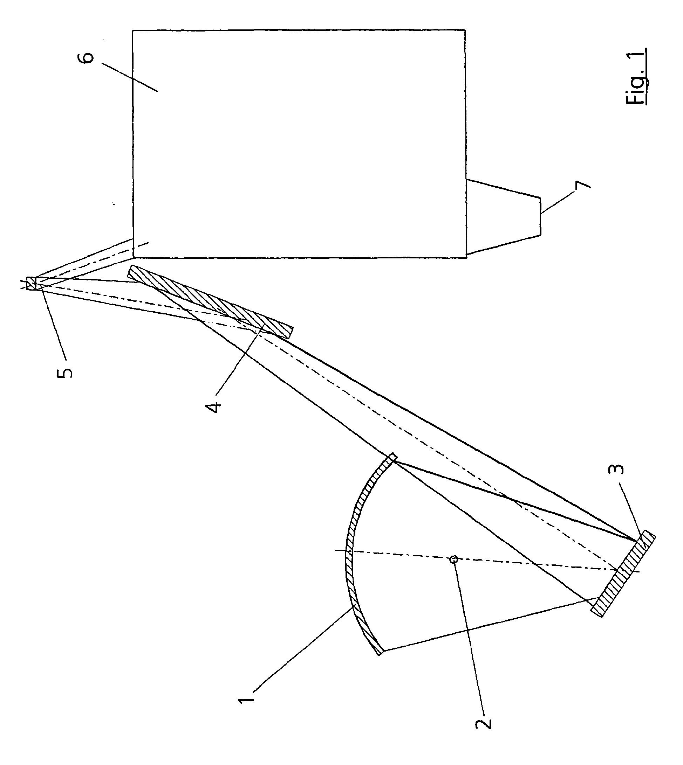

In der Figur 1 ist als ein Beispiel für die Einsatzmöglichkeit eines Kollektorspiegels 1, der sich isofokal verhält, seine Anordnung in einem Beleuchtungssystem für die EUV-Lithographie dargestellt.

Das Licht einer Quelle 2, z.B. einer Laser-Plasmaquelle oder einem Pinch-Plasma oder Dense-Plasma-Fokus, wird über den Kollektorspiegel 1 auf einen Facettenspiegel 3 geworfen. Die Quelle 2 liegt im ersten Fokus des Kollektorspiegels 1. Der zweite Fokus (nicht dargestellt) liegt bei dem dargestellten Ausführungsbeispiel hinter dem Facettenspiegel 3. Von dem Facettenspiegel 3 wird das Licht über einen Umlenkspiegel 4 einem Recticle (Maske) 5 zugeführt. Die Struktur des Recticles 5 wird über ein nicht näher dargestelltes Projektionsobjektiv 6 einem Wafer 7 zur Abbildung zugeleitet.

Durch die Laser-Plasmaquelle 2 erfährt der Kollektorspiegel 1 eine hohe thermische Last, durch welche er seine Form ändert. Diese Formänderung würde normalerweise zu unkontrollierten Beleuchtungsfehlern führen.

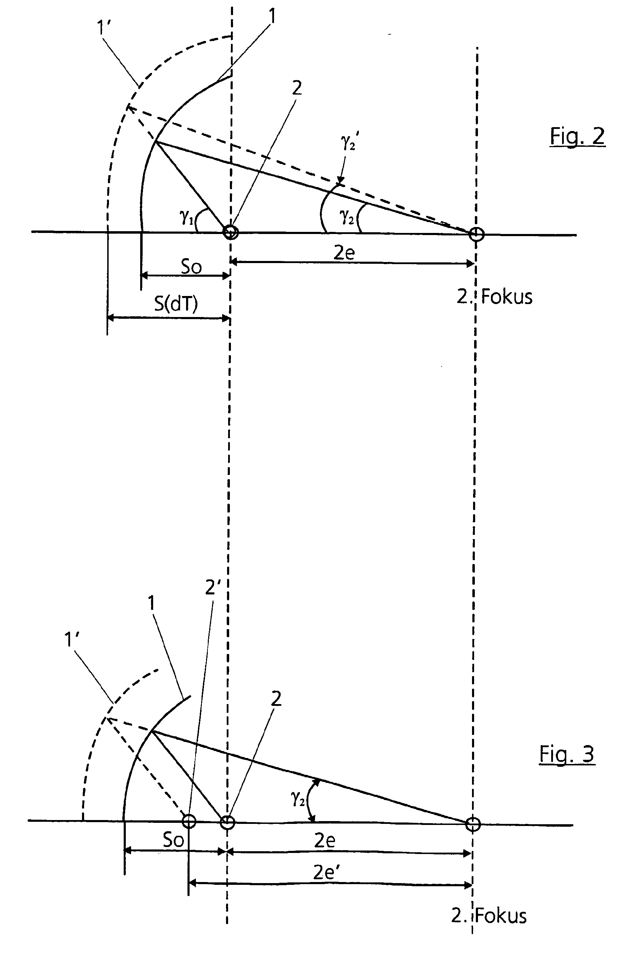

Die Figur 2 zeigt nun in einer Prinzipdarstellung eine kontrollierte Formänderung und Verschiebung des Kollektorspiegels 1, damit die optischen Eigenschaften des Kollektorspiegels beibehalten bleiben. Dargestellt ist dabei eine Lösung, wobei der Kollektorspiegel 1 in z-Richtung derart gezielt verschoben wird und sich seine Form entsprechend einer isofokalen Kurvenschar derart ändert, dass der zweite Fokus bezüglich seiner Lage unverändert bleibt.

In einer guten Näherung lassen sich die die Ellipsenschar beschreibende Parameter $\varepsilon$ und p als lineare Funktion von der Temperaturänderung dT darstellen. Danach gilt:

$$p \approx s_0 \left[ \left(1 + \varepsilon_0\right) + \alpha \left\langle 1 + \varepsilon_0 - \frac{s_0 \varepsilon_0}{a_0} \right\rangle dT \right]$$

Dabei gilt:

p = Halbparameter
2e = Brennpunktsabstand
$S_0$ = Abstand von der Quelle zum Scheitel des Kollektorspiegels $a_0$ = e + $S_0$ und S (dT=0) = $S_0$
Für die Schnittweite = Abstand Quelle zu Spiegelkollektor gilt:

$$s = a - e$$

$\alpha$ = Längenausdehnungskoeffizient des eingesetzten Materials

$\varepsilon$ = Numerische Exzentrizität der Ellipse.

$\gamma_2$ = Öffnungswinkel der Strahlung zwischen dem zweiten Fokus und dem Kollektorspiegel.

Wie aus der Figur 2 ersichtlich ist, bleibt der Brennpunktsabstand 2e erhalten und es ändern sich lediglich der Winkel $\gamma_2$ in $\gamma_2$' und $S_0$ in S (dT).

Figur 3 zeigt die Prinzipdarstellung einer Lösung, wobei der Kollektorspiegel derart ausgelegt ist, dass unter thermischer Last die Vergrößerung, d.h. der Abbildungsmaßstab oder die bildseitige Apertur, sich nicht ändert. Hierzu muß der Abstand von der Quelle 2 zum Bild der Lichtquelle verändert werden. Für diesen vergrößerungserhaltenden Kollektor muß die Exzentrizität $\varepsilon$ bzw. die konische Konstante K konstant bleiben und die Scheitelkrümmung p = R sich linear ändern. Damit folgt für den Halbparameter p:

$$p = s \cdot (\varepsilon + 1) = s_0 \cdot (1 + \alpha \cdot dT) \cdot (\varepsilon + 1) = p_0 \cdot (1 + \alpha \cdot dT),$$

wobei

Apertur der Quelle
Apertur des Strahlenbündels $\qquad p_1 = \sin\gamma_2 = \dfrac{\sin\gamma_1}{\beta_c}$

Vergrößerung des Kollektors $\qquad \beta_c$ = const.

Wie aus der Figur 3 ersichtlich ist, ändert sich dabei auch der Brennpunktabstand 2e in 2e', was bedeutet, dass die Quelle 2 nach 2' verschoben wird. Wie ersichtlich, bleibt dabei der Öffnungswinkel $\gamma_2$ erhalten. Anstelle einer Verschiebung der Quelle 2 könnte grundsätzlich auch mit dem gleichen Ergebnis der zweite Fokus verschoben werden, um den Winkel $\gamma_2$ gleich zu halten. In der Praxis wird man jedoch den zweiten Fokus festhalten und Quelle 2 und Kollektorspiegel 1 entsprechend in z-Richtung verschieben.

Selbstverständlich können anstelle von Ellipsenscharen auch Hyperbel- oder Parabelscharen verwendet werden.

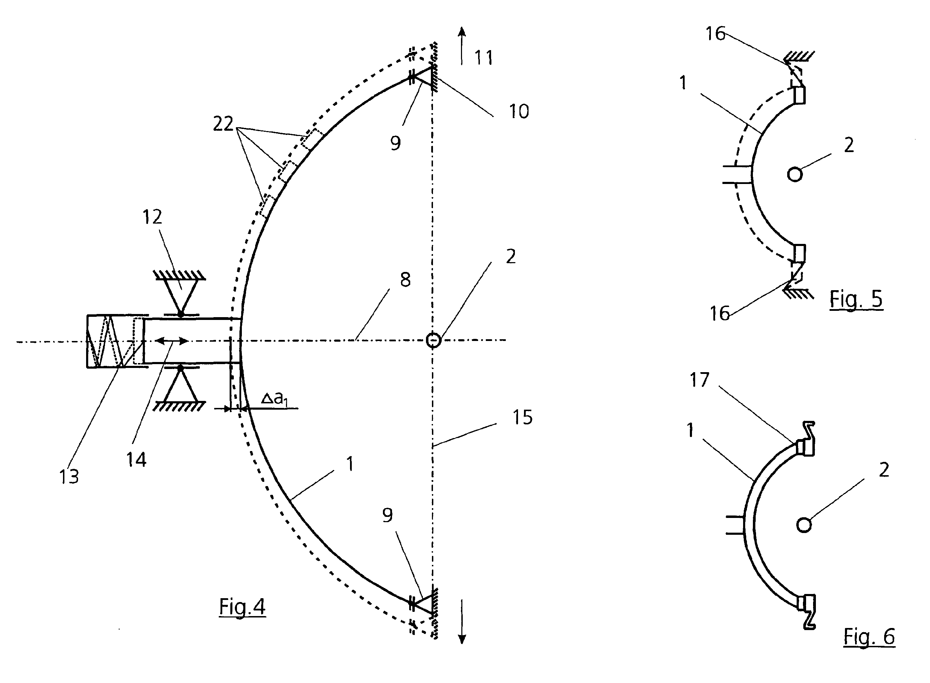

Der Kollektorspiegel 1 wird gemäß den gestellten Forderungen so ausgelegt, dass er sich unter Erwärmung isofokal oder alternativ vergrößerungserhaltend verhält. Dies bedeutet, man läßt eine gezielte Formänderung derart zu, dass sich seine Form entsprechend ändert. Um diese Verformung zu erreichen, sind die verschiedensten konstruktiven Ausgestaltungen möglich. Die nachfolgend anhand der Figuren 4 bis 9 nur schematisch beschriebenen Ausführungsbeispiele sind deshalb nur beispielhaft anzusehen. Sie beziehen sich auf einen isofokalen Kollektorspiegel 1 Bei entsprechend konstruktiver Ausgestaltung des Kollektorspiegels 1, seiner Aufhängung und gegebenenfalls seiner Kühlung ändert sich zwar ebenfalls die Form des Kollektorspiegels 1, aber gezielt derart, dass bestimmte gewünschte optische Eigenschaften jedoch unverändert bleiben.

Gemäß Ausführungsbeispiel nach der Fig. 4 ist der Kollektorspiegel 1 am Umfang über senkrecht zur optischen Achse 8, d.h. zur z-Achse (optische Achse), verschiebbare Lager 9 mit einer Fassung 10 verbunden. Bei einer Erwärmung dehnt sich der Kollektorspiegel 1 aus und die Lager 9 können sich in Pfeilrichtung 11 - entsprechend der Temperatur - verschieben (siehe gestrichelte Darstellung des Kollektorspiegels 1). Gleichzeitig wird der Kollektorspiegel 1 in einer zentralen Führung 12 gegen den Widerstand einer Federeinrichtung 13 nach hinten bzw. von der Quelle 2 weg bewegt. Wie ersichtlich, ergibt sich auf diese Weise eine Abstandsänderung $\Delta a_1$ zwischen der Quelle 2 und dem Vertex. Um eine Isofokalität des Kollektorspiegels zu erhalten bzw. um diesen isotherm bezüglich seiner optischen Eigenschaften zu halten, ist lediglich dafür zu sorgen, dass die Abstandsänderung $\Delta a_1$ derart eingestellt wird, dass sich die gewünschte isofokale Ellipsenschar mit den daraus resultierenden gleichen optischen Wirkungen ergibt. In Kenntnis der verwendeten Materialien, der Ausdehnungskoeffizienten, der Brennpunktabstände und weiterer bekannter Parameter läßt sich die erforderliche Abstandsänderung jedoch entweder rechnerisch oder empirisch ermitteln.

Unter thermischer Last sollte der Kollektorspiegel 1 eine Verschiebung entlang der z-Achse durchführen, d.h. die Schnittweite muß sich ändern. Hierfür ist es auch vorteilhaft, den Spiegel in der Ebene 15 der Quelle 2 zu fassen. Bei einer thermischen Ausdehnung führt er dann automatisch eine Bewegung entgegen der z-Achse 8 durch. Die Ellipsen unterscheiden sich dann nur im Abbildungsmaßstab der Quellabbildung bzw. im "Öffnungs-verhältnis" der "bildseitigen" Apertur. Eine solche Änderung des Abbildungsmaßstabs ist jedoch gering und hat im allgemeinen nur vernachlässigbare Auswirkung auf die Performance des Beleuchtungssystems.

Falls die passive Ausführung nicht ausreichend ist, kann die z-Verschiebung durch geeignete Materialien in der Fassung bzw. zwischen der Fassung 10 und dem Kollektorspiegel 1 oder der Lagerung 9 genauer eingestellt werden. Dies kann z.B. durch eine Aufhängung über Biegeelemente 16 erfolgen (siehe Figur 5) oder auch durch ein oder mehrere aktive Komponenten 17 (siehe Figur 6). Die aktiven Komponenten 17 können zwischen dem Kollektorspiegel 1 und der Fassung 10 angeordnet sein. Als aktive Komponenten lassen sich z.B. Werkstoffe mit bestimmten Ausdehnungskoeffizienten verwenden, um die erforderliche Längenverschiebung zu erreichen. Ebenso sind auch reine aktive Betätigungsglieder möglich, wie z.B. pneumatische, hydraulische, magnetostatische, piezoelektrische Glieder und dergleichen. Derartige aktive Glieder haben den Vorteil, dass man sie gezielt und bei Bedarf auch noch mit entsprechenden Anpassungen und Änderungen ansteuern kann.

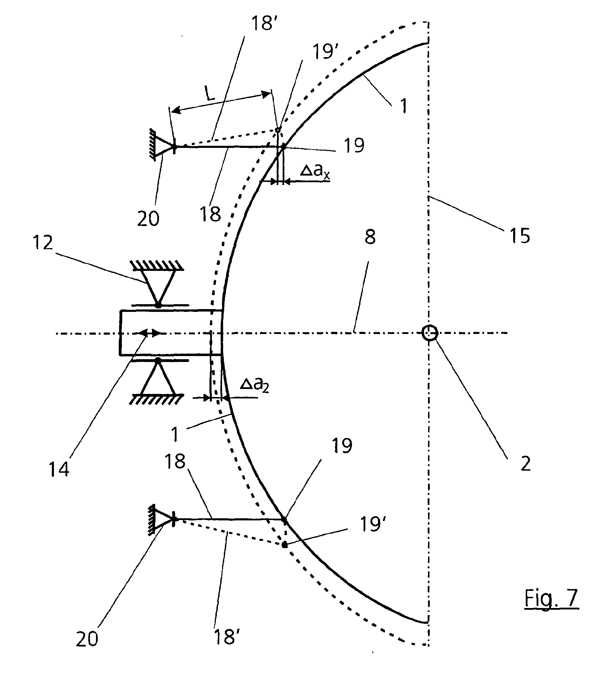

In der Figur 7 ist eine Lagerungsart für einen isofokalen Kollektorspiegel 1 dargestellt, wobei seine "natürliche" Verschiebung $\Delta a_1$ zusätzlich noch verstärkt wird. Hierzu sind mehrere Streben 18 über den Umfang verteilt an dem Kollektorspiegel 1 angeordnet. Sie befinden sich dabei in einem Umfangsbereich zwischen der z-Achse 8 und dem Außenumfang. Die Streben 18 sind an einem Ende jeweils über einen Gelenkpunkt 19 mit dem Kollektorspiegel 1 verbunden, während sich das andere Ende jeweils gelenkig an einer Lagerstelle 20 stützt. Die Längsachsen der Streben 18 erstrecken sich parallel zur z-Achse 8. Erfährt der Kollektorspiegel 1 nun eine Temperaturerhöhung, so dehnt er sich aus und gerät in die gestrichelte Lage. Gleichzeitig verschieben sich dadurch auch die Streben 18 und ihre Gelenkpunkte in die gestrichelten Lagen 18' und 19', wodurch sich der Abstand der Quelle 2 von dem Vertex bzw. dem Scheitelpunkt des Kollektorspiegels 1 zusätzlich noch um den Wert $\Delta a_x$ ändert. Die Gesamtverschiebung des Kollektorspiegels 1 beträgt somit $\Delta a_2 = \Delta a_1 + \Delta a_x$. Über die Längen L der Streben 18 kann $\Delta a_x$ wunschgemäß so eingestellt werden, dass die Isofokalität erreicht wird.

Durch die Verschwenkung der Streben 18 nach außen tritt eine entsprechende Verkürzung bezüglich der Projektion auf die z-Achse und damit der zusätzliche Weg $\Delta a_x$.

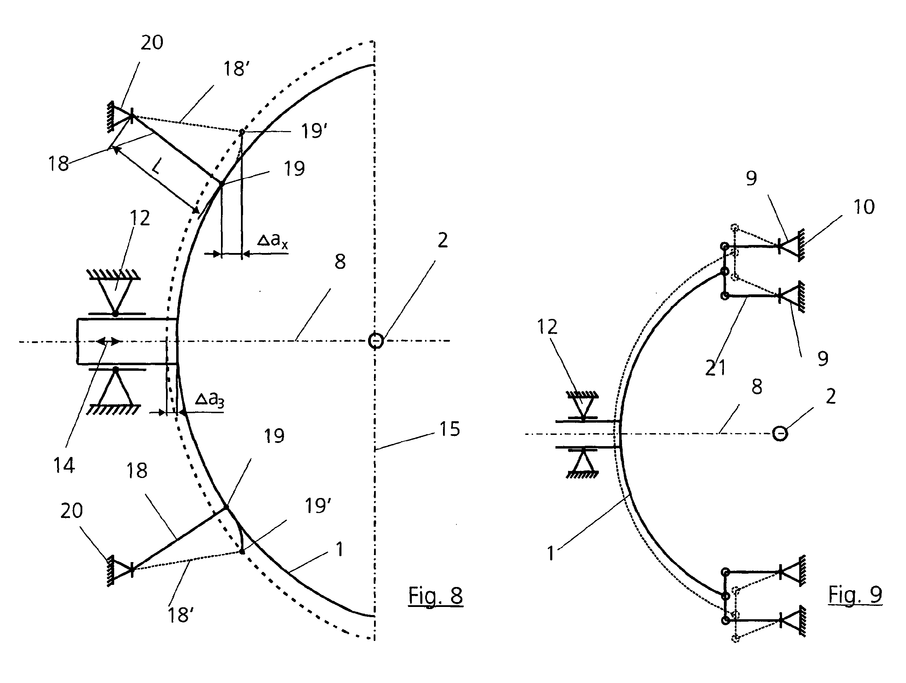

In der Figur 8 ist eine Ausgestaltung prinzipmäßig dargestellt, wobei das umgekehrte Verhalten erreicht wird. In diesem Falle sind ebenfalls über den Umfang verteilt Streben 18 vorgesehen, welche zwischen der z-Achse 8 und dem Außenumfang des Kollektorspiegels 1 liegen und welche ebenfalls an einem Ende jeweils über ein Gelenk 19 mit dem Kollektorspiegel 1 verbunden und mit dem anderen Ende in einer Lagerstelle 20 gelagert sind.

Die Längsachsen der Streben 18 sind in diesem Fall jedoch schräg zur z-Achse derart angeordnet, dass bei einer Verschiebung des Kollektorspiegels 1 nach hinten die Streben 18 dieser Verschiebung entgegenwirken und zwar wiederum um ein Maß $\Delta a_x$. In diesem Falle gilt für die Verschiebung des Kollektorspiegels 1: $\Delta a_3 = \Delta a_1 - \Delta a_x$. Auch hier kann über die Längen L der Streben 18 $\Delta a_x$ eingestellt werden und somit eine entsprechende Gesamtverschiebung des Kollektorspiegels 1 derart erreicht werden, dass die Isofokalität gegeben ist.

Ob die Ausgestaltung nach der Figur 7 mit der Erhöhung des Gesamtverschiebeweges oder nach der Figur 8 mit der Reduzierung des Gesamtverschiebeweges zu wählen ist, richtet sich jeweils nach den spezifischen Einsatzverhältnissen und Parametern.

In der Figur 9 ist prinzipmäßig eine Lagerungsart für den Kollektorspiegel 1 dargestellt, wobei die Lagerung über ein Parallelogramm 21 mit der Fassung 10 erfolgt.

Im Bedarfsfalle können auch noch diverse Übersetzungen vorgesehen werden, um die gewünschte Isofokalität des Kollektorspiegels 1 zu erreichen.

Gegebenenfalls kann zusätzlich noch eine Kühleinrichtung vorgesehen sein, die in der Figur 4 lediglich prinzipmäßig mit dem Bezugszeichen "22" angedeutet ist. Da sich Kollektorspiegel 1, insbesondere bei Verwendung von Laser-Plasmaquellen, ungleichmäßig über den Umfang verteilt erwärmen, sind die Kühlkanäle 22 so anzuordnen, dass lokale Kühlungen derart durchgeführt werden, dass sich insgesamt gesehen eine wenigstens weitgehend gleichmäßige Temperatur für den Kollektorspiegel 1 ergibt.

Durch die Verschiebung des Kollektorspiegels 1 bei Temperaturerhöhung verändert sich auch - allerdings nur in einem geringen Umfang - der Vergrößerungsfaktor.

**Patentansprüche**

1. Vorrichtung zur Strahlenbündelung, mit einer Lichtquelle (2), insbesondere einer Laser-Plasmaquelle, und mit einem Kollektorspiegel (1), der das Licht der Lichtquelle (2) im zweiten Fokus virtuell oder reell sammelt, insbesondere für die Halbleiter-Lithographie mit EUV-Strahlung, und mit einer Weiterleitung und nachfolgenden Strahlformung in ein Beleuchtungssystem, **dadurch gekennzeichnet, dass** der Kollektorspiegel (1) derart gelagert ist, dass durch Temperaturänderungen Form und Lage des Kollektorspiegels (1) geändert werden, wobei durch diese Temperaturänderungen der Kollektorspiegel (1) derart in z-Richtung d.h. entlang der optische Achse verschoben wird, dass die Lage des zweiten Fokus bei den Temperatur änderungen unverändert bleibt.

2. Vorrichtung nach Anspruch 1, **dadurch gekennzeichnet, dass** der Kollektorspiegel (1) derart in z-Richtung d.h entlang der optischen Achse verschoben wird und dass seine Form bei Temperaturänderungen derart verändert, dass der Öffnungswinkel ($\gamma_2$) der Strahlung zwischen dem Kollektorspiegel (1) und dem zweiten Fokus gleich bleibt, wobei sich die Lage des zweiten Fokus entsprechend dem Öffnungswinkel ($\gamma_2$) zufolge ändert.

3. Vorrichtung nach Anspruch 1 oder 2, **dadurch gekennzeichnet, dass** der Kollektorspiegel (1) in der Ebene der Lichtquelle (2) gefasst ist.

4. Vorrichtung nach Anspruch 3, **dadurch gekennzeichnet, dass** die Verschiebung durch eine passive Formänderung des Kollektorspiegels (1) an seinem Umfang und/oder dessen Fassung (10) durchgeführt wird.

5. Vorrichtung nach Anspruch 3, **dadurch gekennzeichnet, dass** der Kollektorspiegel (1) an seinem Umfang über ein Parallelogramm (21) in der Fassung (10) gelagert ist.

6. Vorrichtung nach Anspruch 3, **dadurch gekennzeichnet, dass** zur genaueren Einstellung der z-Verschiebung aktive Komponenten (17,18) vorgesehen sind.

7. Vorrichtung nach Anspruch 6, **dadurch gekennzeichnet, dass** die aktiven Komponenten (17,18) zwischen dem Kollektorspiegel (1) und der Fassung (10) angeordnet sind.

8. Vorrichtung nach Anspruch 3, **dadurch gekennzeichnet, dass** der Kollektorspiegel (1) durch eine Aufhängung an seinem Umfang über Biegeelemente (16) mit der Fassung (10) verbunden ist.

9. Vorrichtung nach einem der Ansprüche 1 bis 8, **dadurch gekennzeichnet, dass** der Kollektorspiegel (1) mit seiner Fassung (10) in Richtung auf die Lichtquelle (2) vorgespannt ist.

10. Vorrichtung nach Anspruch 9, **dadurch gekennzeichnet, dass** zur Vorspannung eine Federeinrichtung (13) vorgesehen ist.

11. Vorrichtung nach einem der Ansprüche 1 bis 10, **dadurch gekennzeichnet, dass** der in der Ebene der Lichtquelle (2) an seinem Umfang gefasste Kollektorspiegel (1) bei einer anisotropischen thermischen Last mit inhomogen verteilten Kühleinrichtungen (22) derart versehen ist, dass im Kollektorspiegel (1) eine wenigstens annähernd gleichmäßige Temperaturverteilung erreichbar ist.

## Claims

1. Device for beam concentration having a light source (2), in particular a laser plasma source, and having a collector mirror (1) which collects the light of the light source (2) in a virtual or real fashion at the second focus, in particular for semiconductor lithography with EUV radiation, and having further conduction and subsequent beam shaping in an illumination system, **characterised in that** the collector mirror (1) is mounted such that the shape and position of the collector mirror (1) are modified by temperature changes, the collector mirror (1) being displaced in the z direction i.e. along the optical axis by these temperature changes so that the position of the second focus remains unmodified as a result of the temperature changes.

2. Device according to Claim 1, **characterised in that** in the event of temperature changes, the collector mirror (1) is displaced in the z direction i.e. along the optical axis and its shape is modified so that the aperture angle ($\gamma_2$) of the radiation between the collector mirror (1) and the second focus remains the same, the position of the second focus being modified in accordance with the aperture angle ($\gamma_2$).

3. Device according to Claim 1 or 2, **characterised in that** the collector mirror (1) is framed in the plane of the light source (2).

4. Device according to Claim 3, **characterised in that** the displacement is carried out by a passive shape change of the collector mirror (1) on its circumference and/or of its frame (10).

5. Device according to Claim 3, **characterised in that** the collector mirror (1) is mounted on its circumference via a parallelogram (21) in the frame (10).

**6.** Device according to Claim 3, **characterised in that** active components (17, 18) are provided for more accurate adjustment of the z displacement.

**7.** Device according to Claim 6, **characterised in that** the active components (17, 18) are arranged between the collector mirror (1) and the frame (10).

**8.** Device according to Claim 3, **characterised in that** the collector mirror (1) is connected by a suspension on its circumference via flexural elements (16) to the frame (10).

**9.** Device according to one of Claims 1 to 8, **characterised in that** the collector mirror (1) is prestressed by its frame (10) in the direction of the light source (2).

**10.** Device according to Claim 9, **characterised in that** a spring instrument (13) is provided for the prestress.

**11.** Device according to one of Claims 1 to 10, **characterised in that** in the event of an anisotropic thermal load, the collector mirror (1) framed on its circumference in the plane of the light source (2) is provided with inhomogeneously distributed cooling instruments (22), so that an at least approximately uniform temperature distribution can be achieved in the collector mirror (1).

**Revendications**

**1.** Dispositif pour la concentration de rayons, comprenant une source lumineuse (2), en particulier une source laser-plasma et un miroir collecteur (1) qui collecte virtuellement ou réellement la lumière de la source lumineuse (2) dans le second foyer, en particulier pour la lithographie de semi-conducteurs comportant un rayonnement EUV, et une transmission et mise en forme ultérieure des rayons dans un système d'éclairage, **caractérisé en ce que** le miroir collecteur (1) est monté de manière que la forme et la position du miroir collecteur (1) soient modifiées par des variations de la température, le miroir collecteur (1) étant déplacé en translation dans la direction z, c'est-à-dire le long de l'axe optique sous l'effet de ces variations de la température afin que la position du second foyer reste inchangée en présence des variations de la température.

**2.** Dispositif selon la revendication 1, **caractérisé en ce que** le miroir collecteur (1) est déplacé en translation dans la direction z, c'est-à-dire le long de l'axe optique, et **en ce que** sa forme est modifiée en présence de variations de la température de telle manière que l'angle d'ouverture ($\gamma_2$) du rayonnement entre le miroir collecteur (1) et le second foyer reste inchangé, la position du second foyer variant en fonction de l'angle d'ouverture ($\gamma_2$).

**3.** Dispositif selon la revendication 1 ou 2, **caractérisé en ce que** le miroir collecteur (1) est maintenu par une monture dans le plan de la source lumineuse (2).

**4.** Dispositif selon la revendication 3, **caractérisé en ce que** le déplacement en translation est exécuté par une modification passive de la forme du miroir collecteur (1) au niveau de sa périphérie, et/ou de sa monture (10).

**5.** Dispositif selon la revendication 3, **caractérisé en ce que** le miroir collecteur (1) est suspendu dans la monture (10) au niveau de sa périphérie par l'intermédiaire d'un parallélogramme (21).

**6.** Dispositif selon la revendication 3, **caractérisé en ce que** des composants actifs (17, 18) sont prévus pour le réglage précis de la translation dans la direction z.

**7.** Dispositif selon la revendication 6, **caractérisé en ce que** les composants actifs (17, 18) sont disposés entre le miroir collecteur (1) et la monture (10).

**8.** Dispositif selon la revendication 3, **caractérisé en ce que** le miroir collecteur (1) est relié à la monture (10) par une suspension au niveau de sa périphérie, au moyen d'éléments de flexion (16).

**9.** Dispositif selon l'une des revendications 1 à 8, **caractérisé en ce que** le miroir collecteur (1), avec sa monture (10), est soumis à une précontrainte en direction de la source lumineuse (2).

**10.** Dispositif selon la revendication 9, **caractérisé en ce que**, pour la précontrainte, il est prévu un dispositif à ressort (13).

**11.** Dispositif selon l'une des revendications 1 à 10, **caractérisé en ce qu'**en présence d'une charge thermique anisotropique, le miroir collecteur (1) maintenu par sa monture au niveau de sa périphérie dans le plan de la source lumineuse (2) est pourvu de dispositifs de refroidissement (22) répartis de façon inhomogène, afin d'obtenir une répartition au moins approximativement uniforme de la température dans le miroir collecteur (1).

Fig. 1

Fig. 2

Fig. 3

Fig. 5

Fig. 6

Fig. 4

Fig. 7

Fig. 9

Fig. 8